# EUROPEAN PATENT APPLICATION

(11) **EP 3 531 462 A1**
(43) Date of publication of application: **28.08.2019**
(21) Application number: 18158263.6
(22) Date of filing: 23.02.2018
(51) Int. Cl.: H01L 51/00

(54) **TRANSPARENT CONDUCTIVE FILM**

(71) Applicant: BASF Coatings GmbH, 48165 Münster (DE)
(72) Inventor: CHO, Boram, 4002 Basel (CH); Dr. FLORES, Jean-Charles, 4002 Basel (CH); REINKE, Michael, 4002 Basel (CH); Prof. SUNG, Myung Mo, 133-791 Seoul (KR); JUNG, Jin Won, 133-791 Seoul (KR)
(74) Representative: BASF IP Association

(57) **Abstract**

The present invention is in the field of transparent conductive films. In particular, the present invention relates to a transparent conductive film comprising
(a) at least two layers containing zinc oxide
(b) a layer containing an organic compound between the two layers containing zinc oxide,
(c) a metallic dopant other than zinc.

## Description

The present invention is in the field of transparent conductive films, in particular organic-inorganic hybrid transparent conductive films.

Transparent conductive films are widely used as electrodes in opto-electronic devices, such as solar cells or light-emitting diodes. Typically, indium-tin oxide (ITO) is used as material in conductive films. However, ITO films are brittle and thus have limited applicability for flexible devices. Superlattice structures offer an alternative.

US 5 523 585 discloses a superlattice structure formed by periodically repeating, in the direction of electron movement, a first and a second semiconductor material regions. However, the conductivity and the flexibility is limited.

US 2017 / 0 121 812 A1 discloses an organic-inorganic superlattice for moisture and oxygen barrier applications. However, it is not indicated how transparent conductive films are obtained from this approach.

It was an object of the present invention to provide a transparent conductive film which maintains its conductivity after bending. It was further aimed at a process for making these films which is easy and reliably yields films of high quality.

These objects were achieved by a transparent conductive film comprising
(a) at least two layers containing zinc oxide
(b) a layer containing an organic compound between the two layers containing zinc oxide,
(c) a metallic dopant other than zinc.

The present invention further relates to a process for preparing a transparent conductive film comprising depositing on a substrate
(a) at least two layers containing zinc oxide
(b) a layer containing an organic compound between the two layers containing zinc oxide,
(c) a metallic dopant other than zinc.

The present invention further relates to the use of the film according to the present invention as electrode in an opto-electronic device.

Preferred embodiments of the present invention can be found in the description and the claims. Combinations of different embodiments fall within the scope of the current invention.

The film according to the present invention is transparent. Transparent in the present context means that the conductive metal oxide film transmits at least 50 % of the intensity of light at a wavelength of 550 nm shined on the film parallel to the surface normal, more preferably at least 70 %, in particular at least 80 %.

The film according to the present invention is conductive, which means that the film is electrically conductive. Preferably, the film has a sheet resistance of 10 000 Ω/sq or less, more preferably 7000 Ω/sq or less, even more preferably 5000 Ω/sq or less, in particular 4000 Ω/sq or less. Preferably, the film has a resistivity of 0.03 Ω·cm or less, more preferably 0.02 Ω·cm or less, even more preferably 0.015 Ω·cm or less, in particular 0.01 Ω·cm or less. Both the sheet resistance and the resistivity are usually measured at a temperature of 20 °C. Preferably, the sheet resistance and the resistivity of the films are measured using the four-point-probe technique.

The film according to the present invention comprises multiple layers, wherein at least two layers contain zinc oxide, so typically ZnO. Preferably, these layers contain at least 50 wt.-% ZnO, more preferably at least 70 wt.-% ZnO, in particular at least 90 wt.-% ZnO. The layer containing zinc oxide can be amorphous, partially crystalline or crystalline, preferably it is crystalline. The at least two layers containing zinc oxide can have the same thickness or different thicknesses, preferably they have the same thickness. The layer containing zinc oxide preferably has a thickness of 0.1 to 100 nm, more preferably 1 to 10 nm, in particular 2 to 5 nm. Preferably, the layer containing zinc oxide has a uniform thickness, which means that the thickness at the thickest position of the layer is less than double of the thickness at the thinnest position, more preferably less than 1.5 the thickness at the thinnest position. The film according to the present invention comprises at least two layers containing zinc oxide, preferably at least three, more preferably at least five, in particular at least ten.

The film according to the present invention further comprises a layer containing an organic compound between the two layers containing zinc oxide. If the film comprises more than two layers containing zinc oxide, the film preferably comprises alternatingly a layer containing zinc oxide and a layer containing an organic compound, such that each layer containing an organic molecule is in between two layers containing zinc oxide, wherein other layers may be in between these layers. The layer containing an organic compound is preferably thinner than the layer containing zinc oxide. If more than one layer containing an organic compound is present, they can have the same thickness or a different one, preferably they have the same thickness. The layer containing an organic compound preferably has a thickness of 0.05 to 5 nm, more preferably 0.1 to 1 nm. The layer containing an organic compound can be a monolayer, i.e. having a thickness on the order of one molecule, or a sub-monolayer.

The layer containing an organic compound preferably contains more than 98 wt.-% of nonmetals, preferably more than 99 wt.-%, in particular completely or essentially completely. It is even more preferable that the nonmetals are C, H, O, N, S, Se and/or P. The layer containing an organic compound can contain one organic compound or more than one organic compounds, for example two or three. The layer containing an organic compound preferably contains a sulfur-containing compound. The sulfur in the sulfur-containing compound is preferably in the oxidation state -2, -1 or 0, which is minus two, minus one or zero, e.g. an organic thiol, an organic thioether, or an organic dithioether. An organic thiol is preferred. The sulfur-containing compound can contain one or more than one sulfur atoms. Preferably, the sulfur-containing compound contains one sulfur atom. More preferably, the sulfur-containing compound is an aromatic thiol. The thiol can be directly bond to the aromatic part of the molecule or via a linker such as a methylene group, preferably it is directly bond to the aromatic group. The sulfur-containing compound is even more preferably a thiophenol derivative. Preferably, the sulfur-containing molecule further contains one or more hydroxyl groups. Some preferred examples for sulfur-containing compounds are given below.

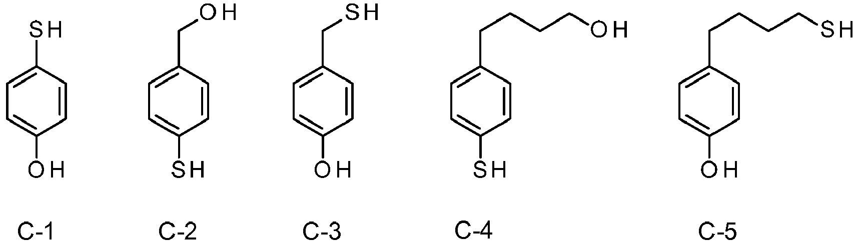

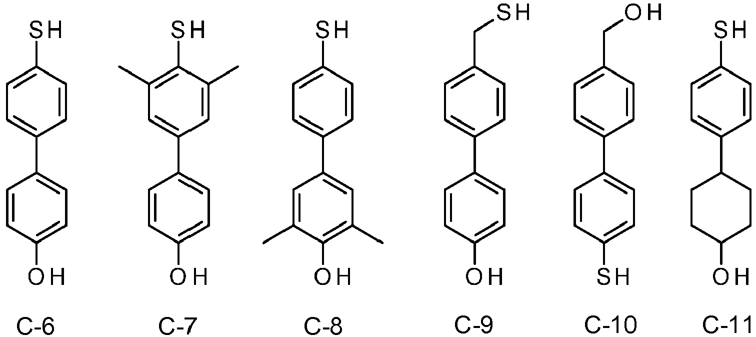

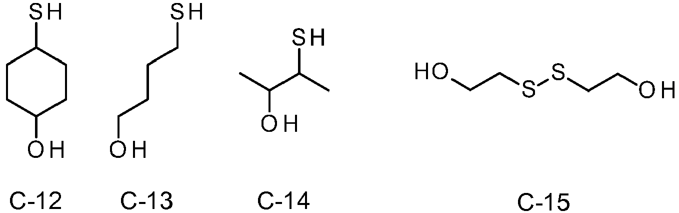

Particularly preferred are 4-mercaptophenol (C-1) and 4-mercapotbenzylic alcohol (C-2). It is also possible to make the organic layer with different organic molecules with the provision that at least one organic molecule is sulfur-containing.

Preferably, the sulfur-containing compound contains at least two sulfur atoms, more preferably two sulfur atoms. The sulfur atoms in the sulfur-containing compound are independent of each other parts of function groups as described above. Thiols are preferred, dithiols are more preferred. Preferably, two thiol groups are attached to an aromatic system, such as benzene, either directly or via a linker such as a methylene group. Some preferred examples for sulfur-containing compounds containing two sulfur atoms are given below.

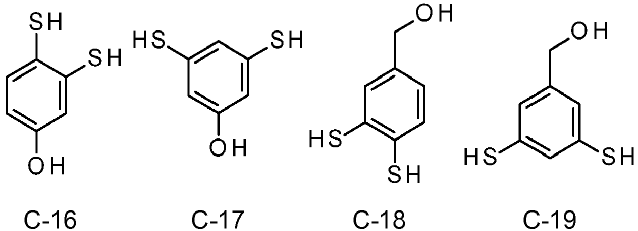

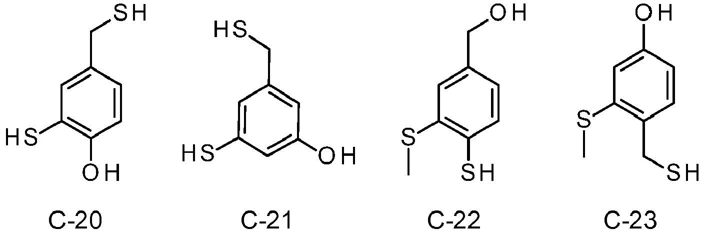

If the organic compound in the layer containing an organic compound contains hydroxy, thiol or other groups which can be deprotonated, it is possible that the group remains protonated or that it is deprotonated and coordinates to a metal, or that some are protonated and some are deprotonated and coordinate to a metal.

The film according to the present invention further comprises a metallic dopant other than zinc. The metallic dopant can be Li, Be, Na, Mg, Al, K, Ca, Sc, Ti, V, Cr, Mn, Fe, Co, Ni, Cu, Ga, Rb, Sr, Y, Zr, Nb, Mo, Tc, Ru, Rh, Pd, Ag, Cd, In Sn, Cs, Ba, La, Ce, Pr, Nd, Pm, Sm, Eu, Gd, Tb, Dy, Ho, Er, Tm, Yb, Lu, Hf, Ta, W, Re, Os Ir, Pt, Au, Hg, TI, Bi. Preferably, the metallic dopant is Mo, Ta, In, V, Sn, W, Mn, Al, Ga, Ti, Zr, or Hf, in particular Al. The film can contain one metallic dopant other than zinc or more than one, for example two or three.

The film typically contains less metallic dopant than zinc. Preferably the atomic ratio of the metallic dopant and zinc is 10⁻¹⁰ to 0.1, more preferably 10⁻⁹ to 0.01, in particular 10⁻⁸ to 10⁻³. There is no particular restriction to where the metallic dopant is placed as it is believed that at least part of the metallic dopant can migrate in the film. However, preferably the concentration of metallic dopant is highest at the interface between the layers containing zinc oxide and the layers containing an organic compound.

The film preferably comprises a substrate, in particular a transparent substrate. Various transparent substrates can be used, such as glass or polymers. Polymers are preferred. Polymers include polyesters such as polyethylene terephthalate (PET) or polyethylene naphthalene-dicarboxylic acid (PEN); polyimides; polyacrylates such as poly methyl methacrylate (PMMA); polyacrylamides; polycarbonates such as poly(bisphenol A carbonate); polyvinylalcohol and its derivatives like polyvinyl acetate or polyvinyl butyral; polyvinylchloride; polyolefins such as polyethylene (PE) or polypropylene (PP); polycycloolefins such as polynorbornene; polyethersulphone; polyamides like polycaprolactam or poly(hexamethylene adipic amide); cellulose derivatives such as hydroxyethyl cellulose, hydroxypropyl cellulose, methyl cellulose, methyl hydroxylpropyl cellulose or nitrocellulose; polyurethanes; epoxy resins; melamine formaldehyde resins; phenol formaldehyde resins. Polymers include copolymers such as poly(ethylene-co-norbornene) or poly(ethylene-co-vinylacetate). Polyesters and polycycloolefins are preferred.

The substrate can have any size and shape. Preferably the substrate is a film. The thickness of the substrate film depends on the application. If the barrier film is bent around a radius of more than 10 mm, the substrate film preferably has a thickness of 100 to 1000 µm, more preferably 100 to 500 µm, for example 100 to 200 µm. If the barrier film is bent with a radius of less than 10 mm the substrate film preferably has a thickness of 1 to 100 µm, more preferably 10 to 70 µm, such as 40 to 60 µm.

The surface of the substrate is preferably of high planarity. High planarity in the context of the present invention means that the highest point on the surface is not more than 100 nm higher than the lowest point on the surface, preferably not more than 50 nm. The planarity can be measured with atomic force microscopy, preferably in tapping mode.

Substrates are often not available with high planarity, e.g. due to small scratches, or particles such as dust adhered to their surface. It is therefore preferred that the barrier film further comprises a planarization layer to avoid damaging such as puncturing the laminate. More preferably the planarization layer is in between the substrate and the laminate. In this case the planarization layer can additionally serve to better hold together the substrate and the laminate, particularly upon bending or heating. Planarization layers can comprise organic polymers such as acrylates or epoxy, ceramics such as carbides, e.g. SiC, or organic-inorganic hybrid materials such as polyalkylsiloxanes. Organic polymers are preferred.

Often the planarization layer is made by depositing the material making up the planarization layer on the substrate before applying the laminate. In the case of organic polymers a liquid comprising a monomer is cast on the substrate and then cured, for example by heating or by UV initiation. UV initiation is preferred, more preferably the liquid comprising the monomer further comprises a curing aid such as a functionalized benzophenone. Preferably the liquid comprising the monomer comprises a mixture of mono- and difunctional monomers such that cross-linked organic polymers are obtained after curing. Planarization layers comprising ceramics are usually obtained by sputtering the material onto the substrate. Planarization layers comprising organic-inorganic hybrid materials can be obtained by casting a solution comprising an organic-inorganic precursor on the substrate, evaporating the solvent and condensing the organic-inorganic precursor, for example by heating. This process is often referred to as sol-gel process. An example for an organic-inorganic precursor is alkyl-trialkoxysilane. Preferably the precursor is functionalized with a UV curable side group, for example acrylate. In this way the organic-inorganic hybrid material can be cross-linked.

Preferably the material making up the planarization layer has a modulus of elasticity in between that of the substrate material and that of the laminate, for example 10 to 30 GPa. The method of determining the modulus of elasticity is described in ISO 527-1 (Plastics - Determination of tensile properties, 2012).

The film according to the present invention is particularly insensitive towards mechanical stress or strain. Preferably, the sheet resistance of the film increases by less than 10 % after bending the film for 500 times around a radius of 0.5 cm.

The film according to the present invention can be made in various ways. The layers can be deposited from solution or from vapor. Vapor deposition methods are preferred. Such methods include chemical vapor deposition (CVD), sputtering, or atomic layer deposition (ALD). ALD is preferred. For the sake of simplicity, ALD in the context of the present invention comprises both atomic layer deposition as well as molecular layer deposition or mixtures thereof.

Preferably the process for preparing the film comprises the sequence comprising depositing a layer containing zinc oxide, depositing a layer containing an organic compound and depositing a metallic dopant other than zinc, wherein the sequence is performed once or preferably more than once, such as at least twice, at least three time, at least five times or in particular at least ten times, and then depositing another layer containing zinc oxide. Said sequence can have the order of
(1) depositing a layer containing zinc oxide
(2) depositing a layer containing an organic compound and
(3) depositing a metallic dopant other than zinc.

Alternatively, said sequence can have the order of
(1) depositing a layer containing zinc oxide
(2) depositing a metallic dopant other than zinc, and
(3) depositing a layer containing an organic compound.

Said sequence can comprise depositing a metallic dopant other than zinc twice, for example in the following order
(1) depositing a layer containing zinc oxide
(2) depositing a metallic dopant other than zinc,
(3) depositing a layer containing an organic compound, and
(4) depositing a metallic dopant other than zinc.

Typical pressures at which the process is performed range from 1500 to 10⁻⁵ mbar, preferably from 100 to 10⁻³ mbar, more preferably from 10 to 0.1 mbar. It is therefore preferable to run the process in an apparatus in which the pressure can be adjusted such as in a vacuum chamber. The temperature for the process is in the range of -20 to 500 °C, preferably 0 to 300 °C, in particular 50 to 220 °C.

For depositing the layer containing zinc oxide, various zinc-containing compounds can be used. Preferably, metal-organic zinc-containing compounds are used, such as alkyl zinc such as dimethyl zinc; zinc alkoxylates such as dimethoxy zinc; cyclopentadiene adducts like zincocene; zinc carbenes such as zinc N,N'-dimethylimidazol-2-ylidene; zinc halogenides such as zinc chloride. More preferably, the zinc-containing compound is an alkyl zinc, in particular a C₁ to C₄ alkyl zinc.

The deposited zinc-containing compound often has to be converted into zinc oxide. This can be achieved by heating above the decomposition temperature of the zinc-containing compound, preferably in the presence of an oxygen. Preferably, the deposited zinc-containing compound is decomposed by bringing it in contact with oxygen-containing compound, for example water, oxygen, ozone, or an oxygen plasma.

If the layer containing zinc oxide is made by ALD, preferably a sequence comprising depositing a zinc-containing compound and depositing it by bringing it in contact with an oxygen-containing compound is performed at least once, preferably at least five times, more preferably at least 10 times, in particular at least 20 times. Often, the sequence is performed for not more than 1000 times.

For depositing the metallic dopant other than zinc, various metal-containing compounds can be used. Preferably, metal-organic metal-containing compounds are used, such as alkyl metals such as trimethylaluminum or dibutyl tin; metal alkoxylates such as tetramethoxy silicon or tetra-isopropoxy zirconium; cyclopentadiene adducts like ferrocene or titanocene; metal carbenes such as tantalum-pentaneopentylat or bisimidazolidinylenrutheniumchloride; metal halogenides such as germanium tetrabromide or titanium tetrachloride; carbon monoxide complexes like chromium hexacarbonyl or nickel tetracarbonyl. More preferably, the metal-containing compound is an alkyl metal, in particular a C₁ to C₄ alkyl metal. Preferably, the metallic dopant is deposited on a layer containing zinc oxide or on a layer containing an organic compound or both.

For depositing the layer containing an organic compound, the compounds described above can preferably be used. Preferably, the organic compound is deposited on deposited metal-organic compounds. However, if the organic compound is deposited on the layer containing zinc oxide, the surface of the layer containing zinc oxide is reactive, for example due to deposited zinc-containing compound which has not yet been brought in contact with an oxygen-containing compound.

If the process is an ALD process, typically, the surface is exposed to the zinc-containing compound or the organic compound in one ALD cycle for 1 ms to 30 s, preferably 10 ms to 5 s, in particular 50 ms to 1 s. It is preferable to purge the substrate with an inert gas in between exposing the surface to the (semi)metal-containing compound or the sulfur-containing compound of different chemical structure, normally for 0.1 s to 10 min, preferably for 1 s to 3 min, in particular for 10 s to 1 min.

Preferably, the process according to the present invention is performed as a spatial ALD process, i.e. the zinc-containing compound, the metal-containing compound, the organic compound, and oxygen-containing compound are passed through separate orifices which are moved relative to the substrate This means that either the substrate is moved and the orifices are kept immobile or the substrate is kept immobile while the orifices are moved or both the substrate and the orifices are moved. Preferably the speed of motion is from 0.01 to 10 m/s, more preferably 0.02 to 1 m/s, in particular 0.05 to 0.3 m/s. The orifices are arranged such that the zinc-containing compound, the metal-containing compound, the oxygen-containing compound and the organic compound hit the surface of the substrate in the order as described for the process above. In order to avoid reactions in the gas phase it is preferred to place orifices through which an inert gas, such as nitrogen or argon, are passed towards the surface of the substrate between the orifices through which the zinc-containing compound, the metal-containing compound, the oxygen-containing compound and the organic compound is passed.

Preferably the orifices are mounted on a rotating drum around which the substrate is placed, preferably moved. Such an apparatus is described in WO 2011 / 099 858 A1. In case the substrate is flexible an organic-inorganic substrate can thus be deposited on a large substrate in a so-called roll-to-roll process.

The film according to the present invention can be used as electrode in an opto-electronic device. Examples for opto-electronic devices include light-emitting diodes, lasers, solar-cells, or optical sensors.

### Examples

### Substrate Preparation

Polymer film substrates were cut from polyimide (PI) films (thickness: 25 µm). PI polymer film substrates were cleaned with acetone, ethanol, de-ionized water, and blow-dried with nitrogen to remove contaminants.

### Characterization

The thickness of layers containing zinc oxide were measured using spectroscopic ellipsometer (FS-1 multi-wavelength ellipsometer, Film Sense). The film morphology was investigated by atomic force microscopy (AFM, XE-100). The conductivity of the films was measured using four-point-probe technique (HP4155C, Agilent Technologies). UV-visible spectra were obtained using UV-VIS spectrometer (UV-VIS 8453, Agilent Technologies).

### Example 1

Zinc oxide containing layers were deposited onto the PI substrates using diethylzinc (DEZ) and de-ionized water (H₂O) as ALD precursors. Argon (Ar) served as both a carrier and a purging gas. The DEZ and H₂O were evaporated at 20°C. The cycle consisted of 1 s exposure to DEZ, 5 s Ar purge, 1 s exposure to H₂O and 5 s Ar purge. The total flow rate of Ar was 100 sccm. During this procedure, the temperature was kept at 150 °C under the pressure at 400 mbar. The growth rate of ZnO thin film by ALD method was 1.5 Å/cycle. The cycle is performed for n(ZnO) times according to the following table.

Subsequently, a layer containing an organic compound is made using trimethyl aluminum (TMA, Sigma Aldrich: 99%) and 4-mercaptophenol (4MP, Sigma Aldrich: 97%) as precursors. The reaction temperature is lowered to 145 °C. Ar served as both a carrier and a purging gas. The TMA and 4MP were evaporated at 20 °C and 80 °C, respectively. The ALD cycle consisted of 1 s exposure to TMA, 5 s Ar purge, 5 s exposure to 4MP, 60 s Ar purge, 1 s exposure to TMA and 5 s Ar purge. This cycle was performed once.

The deposition process for the zinc oxide containing layer and the layer containing an organic compound as described before is alternatingly performed for N times according to the following table in order to keep the total thickness of all layers containing zinc oxide about the same.

| Example | n(ZnO) | N | Sheet resistance in Ω/sq | Film resistivity in mΩ·cm | Transparency at 550 nm in % |
|---|---|---|---|---|---|
| 1.1 | 67 | 2 | 6830 | 13.7 | 85.0 |
| 1.2 | 34 | 4 | 2740 | 5.48 | 84.3 |
| 1.3 | 27 | 5 | 2520 | 5.04 | 84.0 |
| 1.4 | 22 | 6 | 1900 | 3.83 | 83.7 |
| 1.5 | 19 | 7 | 1860 | 3.75 | 83.3 |
| 1.6 | 17 | 8 | 2500 | 5.04 | 83.0 |
| 1.7 | 15 | 9 | 3420 | 6.89 | 82.6 |

After bending the films around a radius of 0.5 cm for 500 times, the following data was obtained.

| Example | Sheet resistance in Ω/sq | Film resistivity in mΩ·cm |
|---|---|---|
| 1.1 | 7180 | 14.4 |
| 1.2 | 2810 | 5.62 |
| 1.3 | 2570 | 5.14 |
| 1.4 | 1930 | 3.89 |
| 1.5 | 1885 | 3.80 |
| 1.6 | 2510 | 5.06 |
| 1.7 | 3430 | 6.91 |

### Example 2

Films were made according to example 1 with the difference that 2,3-dimercapto-1-propanol (DMP, TCI: 95%) was used instead of 4MP.

| Example | n(ZnO) | N | Sheet resistance in Ω/sq | Film resistivity in mΩ·cm | Transparency at 550 nm in % |
|---|---|---|---|---|---|
| 2.1 | 67 | 2 | 7800 | 15.6 | 85.3 |
| 2.2 | 34 | 4 | 3150 | 6.30 | 85.2 |
| 2.3 | 27 | 5 | 2980 | 5.96 | 85.2 |
| 2.4 | 22 | 6 | 1890 | 3.78 | 85.1 |
| 2.5 | 19 | 7 | 1700 | 3.40 | 85.1 |
| 2.6 | 17 | 8 | 1500 | 3.00 | 85.0 |
| 2.7 | 15 | 9 | 2300 | 4.60 | 85.0 |

After bending the films around a radius of 0.5 cm for 500 times, the following data was obtained.

| Example | Sheet resistance in Ω/sq | Film resistivity in mΩ·cm |
|---|---|---|
| 2.1 | 8300 | 16.6 |
| 2.2 | 3450 | 6.90 |
| 2.3 | 3242 | 6.48 |
| 2.4 | 2058 | 4.12 |
| 2.5 | 1855 | 3.71 |
| 2.6 | 1642 | 3.28 |
| 2.7 | 2445 | 4.89 |

### Example 3

Films were made according to example 1 with the difference that TMA was only used after deposition of 4MP, but not before (example 3.1) or TMA was only used before deposition of 4MP, but not after (example 3.2).

| Example | n(ZnO) | N | Sheet resistance in Ω/sq | Film resistivity in mΩ·cm | Transparency at 550 nm in % |
|---|---|---|---|---|---|
| 3.1 | 17 | 8 | 37000 | 75.9 | 83.1 |
| 3.2 | 17 | 8 | 20000 | 39.4 | 83.1 |

After bending the films around a radius of 0.5 cm for 500 times, the following data was obtained.

| Example | Sheet resistance in Ω/sq | Film resistivity in mΩ·cm |
|---|---|---|
| 3.1 | 38500 | 77.0 |
| 3.2 | 21000 | 42.0 |

### Example 4 (comparative)

For comparative reasons, the following films were made and analyzed:
4.1 Polyimide without any coating
4.2 Polyimide with only zinc oxide deposition under the same conditions as in example 1
4.3 Film as in example 1, but without using 4MP
4.4 Film as in example 1, but without using TMA

| Example | n(ZnO) | N | Sheet resistance in Ω/sq | Film resistivity in mΩ·cm | Transparency at 550 nm in % |
|---|---|---|---|---|---|
| 4.1 | 0 | 0 | ∞ | ∞ | 85.5 |
| 4.2 | 134 | 1 | 11020 | 22.0 | 85.4 |
| 4.3 | 17 | 8 | 5900 | 11.8 | 83.9 |
| 4.4 | 17 | 8 | 151000 | 303 | 83.1 |

After bending the films around a radius of 0.5 cm for 500 times, the following data was obtained.

| Example | Sheet resistance in Ω/sq | Film resistivity in mΩ·cm |
|---|---|---|
| 4.1 | ∞ | ∞ |
| 4.2 | 11865 | 23.7 |
| 4.3 | 6100 | 12.2 |
| 4.4 | 155000 | 303 |

## Claims

1. A transparent conductive film comprising
(a) at least two layers containing zinc oxide
(b) a layer containing an organic compound between the two layers containing zinc oxide,
(c) a metallic dopant other than zinc.

2. The transparent conductive film according to claim 1, wherein the layers containing zinc oxide have a thickness of 1 to 10 nm.

3. The transparent conductive film according to claim 1 or 2, wherein the atomic ratio of the metallic dopant and zinc is 10⁻⁸ to 10⁻³.

4. The transparent conductive film according to any of the claims 1 to 3, wherein the metallic dopant is Mo, Ta, In, V, Sn, W, Mn, Al, Ga, Ti, Zr, or Hf.

5. The transparent conductive film according to any of the claims 1 to 4, wherein the organic compound contains sulfur.

6. The transparent conductive film according to claim 5, wherein the organic compound is an organic thiol.

7. The transparent conductive film according to any of the claims 1 to 6, wherein the film comprises at least ten layers containing zinc oxide.

8. The transparent conductive film according to any of the claims 1 to 7, wherein the film further comprises a transparent flexible substrate.

9. The transparent conductive film according to any of the claims 1 to 8, wherein the film has a sheet resistance of 7000 Ω/sq or less.

10. The transparent conductive film according to any of the claims 1 to 8, wherein the film has a resistivity of 0.02 Ω·cm or less.

11. The transparent conductive film according to any of the claims 1 to 10, wherein the sheet resistance of the film increases by less than 10 % after bending the film for 500 times around a radius of 1 cm.

12. A process for preparing a transparent conductive film comprising depositing on a substrate
(a) at least two layers containing zinc oxide
(b) a layer containing an organic compound between the two layers containing zinc oxide,
(c) a metallic dopant other than zinc.

13. The process according to claim 12, wherein the deposition is performed by atomic layer deposition.

14. The process according to claim 13 or 14, wherein the deposition is performed at a temperature of 100 to 220 °C.

15. Use of the film according to any of the claims 1 to 11 as electrode in an opto-electronic device.
